# EUROPEAN PATENT SPECIFICATION

(11) **EP 3 671 227 B1**
(45) Date of publication and mention of the grant of the patent: **19.04.2023**
(21) Application number: 18213483.3
(22) Date of filing: 18.12.2018
(51) Int. Cl.: G01R 15/16, G01R 15/06, H01B 17/00

(54) **INSULATOR FOR OVERHEAD POWER LINE CONDUCTORS**
ISOLATOR FÜR FREILEITUNGSLEITER
ISOLATEUR DE CONDUCTEURS DE LIGNE ÉLECTRIQUE AÉRIENNE

(43) Date of publication of application: 24.06.2020
(73) Proprietor: 3M Innovative Properties Company, Saint Paul, MN 55133-3427 (US)
(72) Inventor: Stalder, Michael, 47589 Uedem (DE); Hahn, Joerg, 42349 Wuppertal (DE); Kurzhals, Holger, 47839 Krefeld (DE); Schrix, Lars, 47228 Duisburg (DE); van Meijl, Frank, 5712 NK Someren-Eind (NL); Nakamura, Tsunehisa, Machida, Tokyo, 194-0212 (JP)
(74) Representative: Müller, Bruno

(56) References cited:
- EP-A1- 2 853 903
- WO-A1-2018/179017
- CN-U- 202 351 297
- DE-A1-102015 202 598
- FR-A1- 2 698 695
- JP-A- H11 202 000
- US-A1- 2016 020 586
- US-A1- 2016 274 149
- RODRIGUEZ JUAN CARLOS ET AL: "Maximum energy harvesting from medium voltage electric-field energy using power line insulators", 2014 AUSTRALASIAN UNIVERSITIES POWER ENGINEERING CONFERENCE (AUPEC), ACPE, 28 September 2014 (2014-09-28), pages 1-6, XP032691838, DOI: 10.1109/AUPEC.2014.6966633 [retrieved on 2014-11-24]
- "Distributech 2007 Tech Watch Report With Contributions from F. Zavoda (Hydro Quebec), Bob Uluski (EnerNex), and Charlie Williams (S&C Electric Company) ; TechWatch_products_Rev_0", IEEE DRAFT; TECHWATCH_PRODUCTS_REV_0, IEEE-SA, PISCATAWAY, NJ USA, vol. td.dist.da;15.06.08, 30 March 2007 (2007-03-30), pages 1-11, XP068032343, [retrieved on 2007-03-30]

## Description

The present disclosure relates to insulators for conductors of overhead power lines, and to insulators equipped with sensors for such conductors. It relates in particular to insulators in which a voltage sensor is embedded. The disclosure also relates to power distribution networks comprising such insulators.

Overhead power lines distribute electrical energy in power networks, such as national grids, at elevated voltages of more than one kilovolt and high currents of tens of amperes. Network operators are interested in knowing the status of their networks and employ voltage sensors to sense the alternating (AC) voltage of the conductors of their overhead power lines in various locations. Useful types of voltage sensors are voltage dividers, in which at least two impedances (resistors, capacitors, inductors) are serially connected between the power line conductor and electrical ground, so that between the impedances a signal voltage can be picked up that varies proportionally with the voltage of the power line conductor. Once the proportionality factor is determined, the signal voltage is measured in an analogue or digital signal processing unit to derive the voltage of the power line conductor from it.

Overhead power line conductors are suspended on support structures like poles or masts. Since these structures are on electrical ground, and the power line conductors have no insulating sheath, insulators are used to suspend the conductors and keep them at an adequate distance from the support structure and from each other. The body of such insulators is typically of porcelain (ceramic), glass or polymeric materials like silicone rubber or an epoxy resin. Such insulators are designed to provide as high insulation as possible and thereby to minimize the current that flows through them. Currents along their surfaces are kept small by shaping the insulators as skirts or sheds.

The international patent application WO 00/60367 mentions a system for measuring at least one characteristic of a power line supported by a power line pole which includes a pin having an end adapted to engage a sensor. In one aspect, the system comprises a voltage sensor that detects the presence of a voltage between the conductor and electrical ground.

EP 2 853 903 A1 and WO 2018/179017 A1 each discloses an insulator for a medium-voltage or high-voltage overhead comprising a voltage sensor and a signal processing unit.

In attempting to save space and achieve a higher sensing accuracy, lower cost, greater mechanical stability and/or greater reliability for longer lifetime, the present invention provides an insulator for a medium-voltage or high-voltage overhead power line conductor according to independent claim 1. Preferred embodiments are provided in the dependent claims 2 to 12.

Different from traditional insulators, an insulator according to the present disclosure provides a conductive connection between the power line conductor and electrical ground via the impedance elements of the voltage dividing sensor embedded in the insulator body. While traditionally a voltage sensor for a medium-voltage or high-voltage power line conductor required a separate volume and had to be electrically insulated, the present disclosure facilitates voltage sensing in an insulator. Since the voltage sensor is embedded in the insulator, the sensor does not require a dedicated insulation. An insulator with an embedded voltage sensor according to the present disclosure can thus help save cost and space.

Also, a voltage dividing voltage sensor in electrical contact with the power line conductor can provide a higher sensing accuracy, compared to non-contact voltage sensors. The sensing accuracy of some capacitive voltage sensors, for example, is limited by the dielectric of the high-voltage capacitor changing its electrical properties when the temperature or the environmental humidity changes.

A voltage sensor embedded in an insulator body will be less exposed to changes in temperature or humidity, and can therefore provide a higher sensing accuracy.

The term "medium voltage", as used herein, refers to voltages of between 1 kilovolt (kV) and 72 kV, and "high voltage" refers to voltages of 72 kV or more. Medium voltage (MV) and high voltage (HV) are collectively referred to as elevated voltage herein.

MV/HV overhead power lines in the context of the present disclosure are power lines which distribute electrical energy in a larger geographic area at elevated voltages.

An insulator according to the present disclosure comprises an insulator body. The insulator body is generally designed to insulate a MV/HV overhead power line conductor against elements on electrical ground in the typical environment of an overhead power line and under potentially adverse operating conditions such as ice or high wind loads. The insulator body is also designed to support the weight of the power line conductor.

The insulator body is made from an electrically insulating material. It may, for example, be made from a ceramic material (e.g. porcelain or china), a glass material (e.g. toughened glass), or a polymeric material (e.g. a glass-reinforced polymeric material such as an epoxy resin, or a rubber material, such as a silicone rubber material or ethylene propylene diene monomer EPDM) or combinations of such materials. Ceramic materials provide a high dielectric strength and show little degradation over time. Polymeric materials are particularly easy to cast into a desired shape and often provide a cost advantage. It is often straight-forward to embed a voltage sensor into an insulator body comprising a polymeric material, e.g. by overmolding the sensor when manufacturing the insulator body. Hence in certain embodiments the insulator body comprises porcelain, china, a ceramic material, glass and/or a polymeric material, such as an epoxy resin, natural rubber or ethylene propylene diene monomer rubber.

The shape of the insulator body is not particularly limited. It may have the shape of traditional overhead power line conductor insulators, such as, for example, an elongated shape, to provide and maintain a distance between the conductor and the suspension support structure. The necessary distance - and the length of the insulator body - depends on the voltage of the power line conductor. The insulator body may form a plurality of sheds or skirts.

The insulator body may be formed as one single piece. Alternatively, the insulator body may be formed from a plurality of elements, e.g. a plurality of insulator disks, stacked upon each other and connected with each other to form the insulator body.

The voltage sensor is embedded in the insulator body. In certain embodiments, the insulator body comprises a cavity for accommodating the voltage sensor. The cavity may provide enough space to accommodate the voltage sensor only. Alternatively, the cavity may provide more space than necessary for accommodating the voltage sensor only. In this case, the cavity may contain the voltage sensor and an insulation gas or an insulating liquid.

In certain embodiments the insulator body comprises a dielectric (non-conductive) moldable material. Moldable materials, in this context, are materials that can be molded, i.e. that are liquid at a higher temperature and solid at typical operating temperatures of an insulator for an overhead power line.

The voltage sensor can be embedded in the insulator body by molding the insulator body around the voltage sensor. For example, the voltage sensor may be positioned in a mold determining the outer shape of the insulator body, then a moldable material in liquid state is cast into the mold such as to embed the voltage sensor, and the moldable material is then let solidify (e.g. by cooling or curing) to form the insulator body. The voltage sensor is thereby embedded in the solidified insulator body.

The voltage sensor of an insulator according to the present disclosure comprises a first plurality of discrete impedance elements. In the context of the present disclosure, the discrete impedance elements are essential elements of the voltage sensor. The voltage sensor may consist of the first plurality of discrete impedance elements. A voltage sensor according to the present disclosure may comprise other elements, such as, for example, a PCB (printed circuit board) on which some or all of the plurality of discrete impedance elements are mounted.

In certain embodiments, the first plurality of discrete impedance elements is mounted on a PCB. This is a cost-effective means to support the impedance elements and to connect them with each other via conductive traces on a surface of the PCB. It is usually most cost-effective to arrange all discrete impedance elements on one major surface of the PCB. Therefore, generally, and independent of other features, in these embodiments the insulator comprises a printed circuit board having a first major surface and an opposed second major surface, wherein the first plurality of discrete impedance elements is arranged on the first major surface.

An impedance element may be, for example, a resistor, a capacitor, or an inductor. A discrete impedance element is an individual, separate impedance element, that may exist separate from a PCB or conductive traces on a PCB, as opposed to impedance elements formed by conductive traces on a PCB. Examples of discrete impedance elements are surface mount devices ("SMDs") like surface-mount capacitors, surface-mount resistors and surface-mount inductors. A plurality of discrete impedance elements may comprise one resistor and one or more capacitors. A plurality of discrete impedance elements may comprise one resistor and one or more inductances. A plurality of discrete impedance elements may comprise one inductance and one or more capacitors. Generally, the plurality of discrete impedance elements may comprise one or more resistors, and/or one or more capacitors and/or one or more inductances. In certain preferred embodiments the plurality of discrete impedance elements consists of a plurality of discrete capacitors. Resistors, capacitors and inductances are particularly suitable elements to form a voltage divider because they are readily available at moderate cost. Also, their electrical properties are generally precisely specified.

Discrete capacitors are available at high precision and moderate cost. Therefore, in certain embodiments, the first plurality of discrete impedance elements and/or the second plurality of discrete impedance elements is a plurality of discrete capacitors.

According to the present disclosure, the discrete impedance elements are electrically connected in series to be operable as a voltage divider. Generally, voltage dividers are proven and cost-effective means to divide the elevated voltage of the overhead power line conductor and to sense this voltage versus ground. Once the plurality of discrete impedance elements is connected between the voltage contact on elevated voltage of the power line conductor and the ground contact on electrical ground, a signal voltage can be picked up between two discrete impedance elements of the plurality. Because the plurality of discrete impedance elements divides the elevated voltage, the signal voltage is smaller than the elevated voltage. The signal voltage varies proportionally to the elevated voltage. Therefore, the elevated voltage can be sensed by determining the proportionality factor and measuring the signal voltage.

The elevated voltage is divided by the chain of serially connected discrete impedance elements, so that the voltage "behind" each impedance element is lower than "before" it. Where the number of serially-connected impedance elements is greater, the elevated voltage is divided down in more steps. This allows the voltage drop across each impedance element to be smaller, so that there is less electrical stress on each impedance element, which makes the voltage sensor more reliable. For elevated voltages of some kilovolt of the power line conductor, it is advantageous to use ten or more discrete impedance elements. This applies both to the first plurality of impedance elements for sensing the elevated voltage and, if present, to the second plurality of impedance elements for harvesting energy from the power line conductor. Therefore, in certain embodiments, the first plurality of discrete impedance elements and/or the second plurality of discrete impedance elements is a plurality of ten or more discrete impedance elements.

The voltage sensor may comprise a signal contact for picking up the signal voltage from the plurality of discrete impedance elements, wherein the signal voltage is a voltage that varies proportionally to the elevated voltage of the overhead power line conductor. The signal contact may be electrically arranged between two discrete impedance elements of the plurality of discrete impedance elements. A signal wire may be electrically connected to the signal contact for transmitting the signal voltage to outside of the insulator body.

The plurality of discrete impedance elements may be mechanically connected in series, e.g. such as to form a chain. The plurality of discrete impedance elements may be electrically connected by wires or by conductive traces on a PCB or by soldering material. Each impedance element may comprise two contacts for connecting it electrically to other impedance elements or to the ground contact or to the voltage contact.

The plurality of discrete impedance elements is electrically connected between the voltage contact and the ground contact. Thereby, the voltage sensor can sense the voltage between the voltage contact and the ground contact, i.e. it can sense the elevated voltage of the power line conductor versus ground.

Also the position of the voltage contact in or on the insulator is not particularly limited. However, in certain advantageous embodiments the voltage contact is externally accessible. It may, for example, be arranged on an outer surface of the insulator body.

Where the insulator body is an elongated body defining opposite end portions, the voltage contact may be arranged at an end portion of the insulator body.

The position of the ground contact is not particularly limited. However, in certain advantageous embodiments the ground contact is externally accessible. It may, for example, be arranged on an outer surface of the insulator body.

Where the insulator body is an elongated body defining opposite end portions, the ground contact may be arranged at an end portion of the insulator body. Where the voltage contact is arranged at one end portion of the insulator body, the ground contact may be arranged at the opposite end portion of the insulator body. Such an arrangement can reduce the risk of electrical discharges.

It is desirable to measure and process the signal voltage of the voltage sensor in a signal processing unit on or in the insulator and to transmit the value of the sensed voltage in a wireless manner from a wireless transmission device on the voltage sensor to a component of a grid management system. Such a signal processing unit may, for example, be embedded in the insulator body.

Hence generally, in certain embodiments, an insulator according to the present disclosure further comprises a signal processing unit for processing the sensed voltage of the overhead power line conductor, wherein the signal processing unit is embedded, at least partially, in the insulator body.

The signal processing unit is embedded partially or completely. Alternatively, the signal processing unit may be arranged on or in the insulator body, e.g. on an outer surface of the insulator body. In certain alternative unclaimed embodiments, the signal processing unit is arranged at a distance from the insulator body, e.g. at a distance of 10 cm or more, or even of more than a meter.

In principle, the insulator may transmit a signal indicating the sensed voltage of the power line conductor over a wire connected to the signal processing unit. However, in many cases this may be impractical. Hence alternatively an insulator according to the present disclosure may further comprise a wireless transmission device, operationally connected to the voltage sensor, for wirelessly transmitting a signal indicating the sensed voltage of the overhead power line conductor to an outside of the insulator. Such a wireless transmission unit may transmit values of other parameters, like for example temperature or current, sensed by other sensors connected to the insulator. A wireless transmission device may comprise a wireless transmitter/receiver unit and/or an antenna.

Wireless transmission may be performed by using standard industry communication protocols such as, for example, a WLAN protocol, a LoRa long-range wide area network protocol, a Bluetooth protocol, a zigbee protocol, or a similar industry-standard protocol. Custom protocols can alternatively be used.

The signal processing unit may be operated at any base voltage, i.e. it can be operated at the elevated voltage of the conductor, or in an unclaimed example at electrical ground. In any case, the signal processing unit is powered by a difference in voltage (or a difference in electrical potential), and this difference can be a difference vis-à-vis the elevated voltage or in an unclaimed example vis-à-vis electrical ground, or in an unclaimed example vis-à-vis any other base voltage. Typically, the voltage difference for powering the signal processing unit is 3.3 Volt or 5 Volt. In certain embodiments the voltage difference for powering the signal processing unit is 50 Volt or less, in other embodiments it is 100 Volt or less. The voltage difference may be chosen to meet the requirements of the signal processing unit.

Therefore, in certain claimed embodiments of the present insulator, the signal processing unit is powered by a potential difference between a first input voltage and a second input voltage, wherein the first input voltage is the voltage of the overhead power line conductor versus ground, and the second input voltage differs from the first input voltage by 50 Volt or less or by 100 Volt or less.

If a sensor on elevated voltage is to be connected to the signal processing unit, it may be easier to operate both the sensor and the signal processing unit at the elevated voltage, because in that case an electrical discharge between the sensor and the processing unit is unlikely, even if no or only little electrical insulation is used between them. An output signal wire connecting the sensor to the signal processing unit may, for example, be electrically insulated only by a thin layer of insulation.

Where no sensor on elevated voltage is to be connected to the signal processing unit, it may be easier to operate the processing unit at the electrical ground and to supply power at a voltage difference of 50 Volt or less versus ground, or of 100 Volt or less versus ground.

Therefore, in certain other unclaimed embodiments, the signal processing unit is powered by a potential difference between a first input voltage and a second input voltage, wherein the first input voltage is electrical ground, and the second input voltage differs from the first input voltage by 50 Volt or less or by 100 Volt or less.

In order to reduce the risk of electrical discharges, it is generally advantageous to arrange the signal processing unit close to the elevated-voltage portion of the voltage divider (i.e. close to those impedance elements that are on elevated voltage or close to elevated voltage) if the unit is powered by a voltage difference relative to the elevated voltage of the power line conductor. On the other hand, if the unit is powered by a voltage difference relative to electrical ground, it is generally advisable to arrange the signal processing unit at, or close to, the low-voltage portion of the voltage divider (i.e. close to those impedance elements that are on or close to ground voltage).

Also, the voltage divider is generally best placed such that no element on low voltage is close to the voltage contact which connects the insulator, and in particular the voltage divider of the voltage sensor, to the power line conductor. Hence generally it may be useful to arrange the elevated-voltage portion of the voltage divider closer to the voltage contact, and the low-voltage portion further from the voltage contact. This may help avoid larger voltage differences between the low voltage portion and the voltage contact.

Where the insulator according to the present disclosure has an elongated shape defining a first end portion and an opposed second end portion, the risk of discharges may be reduced by arranging the elevated-voltage portion of the voltage divider at one end portion (e.g. the first end portion), and the low-voltage portion of the voltage divider at the opposed end portion (e.g. the second end portion). Where the voltage contact is, for example, placed at the first (elevated voltage) end portion, the signal processing unit may advantageously also be placed at the first end portion, if it is powered by a voltage difference relative to the elevated voltage. Correspondingly the signal processing may better be placed at the second (low voltage) end portion if it is powered by a voltage difference relative to electrical ground.

Hence generally, in certain embodiments, the insulator has an elongated shape defining a first end portion and an opposed second end portion, wherein the voltage contact is arranged at the first end portion and wherein the signal processing unit is arranged at the first end portion.

In other embodiments, the insulator has an elongated shape defining a first end portion and an opposed second end portion, wherein the voltage contact is arranged at the first end portion and wherein the signal processing unit is arranged at the second end portion.

Independent of its placement at an end portion, the signal processing unit may be arranged in the insulator body, on the insulator body, or close to the insulator body, i.e. at a distance of up to 20 cm from the closest point of the insulator body. Alternatively, the signal processing unit may be placed at a distance of a meter or more from the closest point of the insulator body. Unless arranged in the insulator body, the signal processing unit may be arranged in a separate housing.

A signal processing unit which processes the sensed voltage is obviously operationally connected with the voltage sensor of the present insulator. Beyond the voltage sensor, further sensing units may be connected to the signal processing unit. In general, this connection will be done by connecting a wire carrying an output signal of the sensing unit (a "signal wire") to a sensor contact of the insulator, where the output signal can be picked up by the signal processing unit. Where the plurality of discrete impedance elements is arranged on a PCB, the sensor contact may also be arranged on the PCB. As an alternative to a wired connection of a further sensing unit, the further sensing unit may be connected with the signal processing unit in a wireless manner, e.g. via a radio connection or an optical connection.

Hence generally, in certain embodiments, an insulator according to the present disclosure further comprises a sensor contact for electrically connecting a signal wire of a further sensing unit to the processing unit. In certain of these embodiments the further sensing unit comprises a current sensor (e.g. a Rogowski type current sensor), a temperature sensor, a pressure sensor, an acceleration sensor, a force sensor and/or a vibration sensor.

The further sensing unit may be, or may comprise, for example, a current sensor, a temperature sensor, a pressure sensor, an acceleration sensor, a force sensor and/or a vibration sensor. The further sensing unit may be located in or on the insulator, e.g. embedded in the insulator body, or outside the insulator of the present disclosure.

Electrical power for such a signal processing unit and for wireless transmission can be harvested from the power line conductor. Known energy harvesting techniques and circuitries can be used for that purpose. A suitable energy harvesting arrangement is described in co-pending European patent application EP 3 578 998 A1 (EP 18176682.5), according to which a second plurality of serially-connected impedance elements forms a harvesting voltage divider. The harvested energy can, for example, be used to supply electrical power to the signal processing unit and to a wireless transmission device. For example, an AC voltage of 400 Volt can be harvested from the harvesting voltage divider, which is transformed to a supply voltage of 5 Volt to provide the signal processing unit and the wireless transmission unit with power.

The harvested energy can also be used to provide further sensors with power which sense other parameters that are relevant for assessing the state of the power line, such as the current through the conductor, the temperature of the conductor, or vibrations of the conductor.

Therefore, in certain embodiments of the present insulator, the insulator further comprises a second plurality of discrete impedance elements, electrically connected in series between the voltage contact and the ground contact such as to be operable in a second voltage divider for harvesting electrical energy from the power line conductor.

In certain embodiments in which the first plurality of discrete impedance elements is arranged on a first major surface of a PCB, the second plurality of discrete impedance elements may be arranged on the opposed second major surface of the PCB. Alternatively, both pluralities may be arranged on the first major surface. Alternatively, any discrete impedance element of the first plurality may be arranged on the first or the second major surface, and any discrete impedance element of the second plurality may be arranged on the first or the second major surface.

In a further aspect, the present disclosure also provides an electrical power distribution network comprising an overhead power line comprising
a) a medium- or high-voltage overhead power line conductor, and
b) an insulator as described herein, supporting and insulating the overhead power line conductor.

Embodiments of an insulator according to the present disclosure will now be described in more detail with reference to the following Figures. Like reference numerals refer to like elements.
- Fig. 1: Circuit diagram of a capacitive voltage divider;
- Fig. 2: Partially sectional view of a first insulator according to the present disclosure;
- Fig. 3: Partially sectional view of a second insulator according to the present disclosure comprising a wireless transmission device; and
- Fig. 4: Partially sectional view of a third insulator according to the present disclosure.

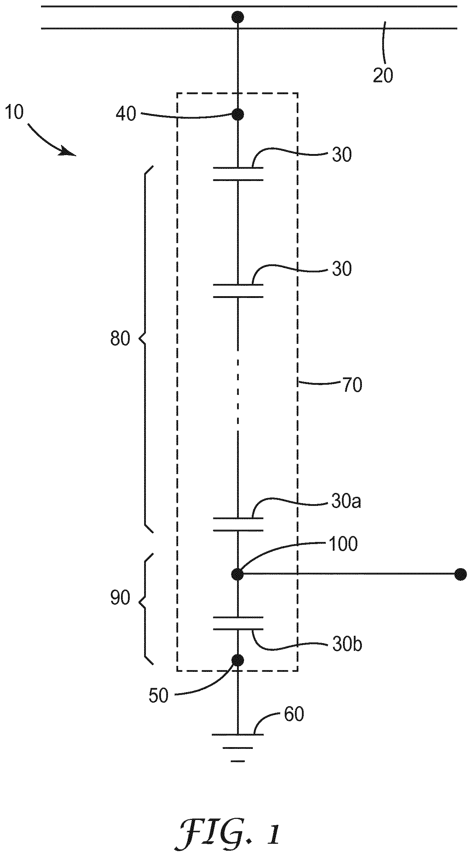

In the circuit diagram of **Figure 1****,** a voltage sensor 10 is shown electrically connected to a MV overhead power line conductor 20. The voltage sensor 10 comprises a plurality of discrete capacitors 30, which are electrically connected in series between a voltage contact 40 and a ground contact 50. The voltage contact 40 facilitates connection to the power line 20, while the ground contact 50 facilitates connection to electrical ground 60.

The discrete impedance elements 30 are operable as a voltage divider 70, indicated as a dashed box, for sensing the elevated voltage of the conductor 20, as they divide the elevated voltage down to electrical ground 60.

The voltage divider 70 comprises the plurality of discrete dividing capacitors 30, which are electrically connected in series with each other such that the voltage divider 70 can sense the elevated voltage of the conductor 20. A subset of the capacitors 30, 30a, connected to the elevated voltage, form a high-voltage side 80 of the voltage divider 70, with the low-voltage side 90 being formed by a single discrete capacitor 30b. Alternatively, the low-voltage side 90 could be formed by two or more discrete capacitors 30b, electrically connected in series or parallel, to obtain a specific combined capacitance.

A signal contact 100 is connected electrically between the high-voltage side 80 and the low-voltage side 90. At the signal contact 100, a divided voltage, also referred to herein as the signal voltage, can be picked up, which varies proportionally with the elevated voltage of the power line conductor 20. The proportionality factor between the elevated voltage and the signal voltage is determined by the ratio of the total impedance of the high-voltage side 80 to the total impedance of the low-voltage side 90 of the voltage divider 70. By measuring the signal voltage at the signal contact 100, the elevated voltage of the conductor 20 can be sensed.

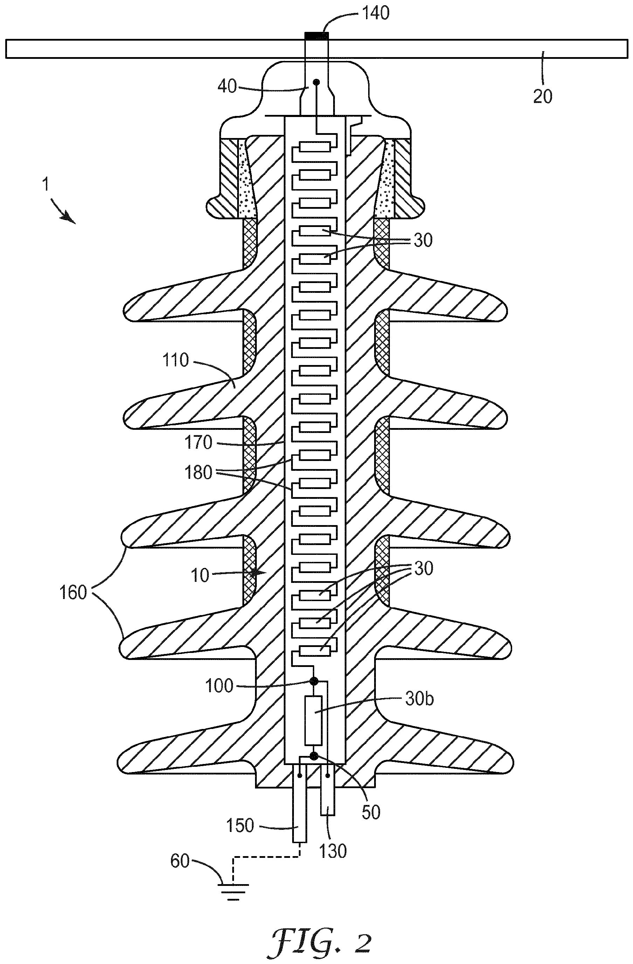

**Figure 2** illustrates, in a partially sectional view, an insulator 1 according to the present disclosure, attached to a medium-voltage overhead power line conductor 20. The insulator 1 comprises an elongated insulator body 110 of a ceramic material. The elongated insulator 1 is attached to the conductor 20 at one of its end portions (the upper end portion in Figure 2) and can be mechanically attached to a suspension support structure at its opposite end portion (the lower end portion in Figure 2).

A voltage sensor 10 is embedded in the insulator body 110. It is formed by nineteen discrete capacitors 30, electrically connected in series and constituting a high-voltage side 80 of a voltage divider 70, and one discrete capacitor 30b ("sensing capacitor" 30b) constituting the low-voltage side 90 of the voltage divider 70. Electrically between the high-voltage side 80 and the low-voltage side 90 of the voltage divider 70, a signal contact 100 is arranged, which picks up the divided voltage and makes it available as the signal voltage outside the insulator 1 at a signal tab 130. The signal voltage is the output of the voltage sensor 10, formed by the capacitors 30, 30b. It can be measured and further processed outside the insulator 1, such as in a separate processing unit.

The "dividing" capacitors 30, 30b are electrically connected in series between a voltage contact 40 and a ground contact 50, which serve to electrically connect the insulator 1 to the power line conductor 20 and to ground 60, respectively. The voltage contact 40 is conductively attached to the power line conductor 20 via a clamp 140. The ground contact 50 can be connected to electrical ground via a grounding tab 150. The insulator 1 can thus be connected between the power line conductor 20 and an element on electrical ground, such as a support structure for the power line conductor 20.

The insulator body 110 provides for adequate electrical insulation of the power line conductor 20 on elevated voltage against elements on lower voltage or on electrical ground and maintains a safe distance between the grounding tab 150 and the voltage contact 40 and the power line conductor 20. Its elongated shape and in particular its sheds 160 minimize currents along the outer surface of the insulator 1 from the voltage contact 40 to the grounding tab 150 or to the signal tab 130. This minimizes the risk of electrical discharges between these elements.

In the insulator 1 of Figure 2, the dividing capacitors 30, 30b are supported by a printed circuit board ("PCB") 170 which also supports conductive traces 180 on its surface which connect the dividing capacitors 30, 30b with each other electrically.

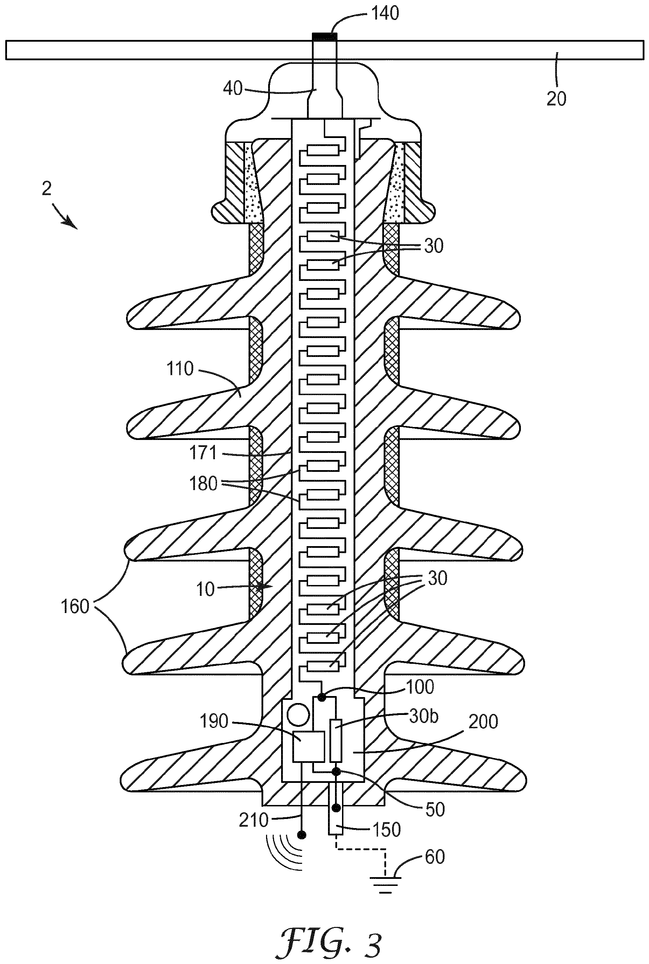

**Figure 3** shows, in a partially sectional view, a second insulator 2 according to the present disclosure, similar to the first insulator 1 of Figure 2, with an embedded voltage sensor 10 and connected to a MV overhead power line conductor 20. The voltage sensor 10 and the insulator body 110 are identical to the corresponding elements of the first insulator 1. The second insulator 2 includes an energy harvesting voltage divider, arranged on the rear side of a double-sided PCB 171 and therefore not visible in Figure 3, while the discrete dividing capacitors 30, 30b of the voltage divider 10 are arranged on the visible front surface of the PCB 171.

The harvesting voltage divider supplies electrical power to a signal processing and communication unit ("SPCU") 190, located on the low-voltage end portion 200 of the PCB 171. For sensing the elevated voltage of the power line conductor 20, the SPCU 190 picks up the signal voltage from the signal contact 100 and uses the signal voltage and data about the total impedance of the high-voltage side 80 and the total impedance of the low-voltage side 90 of the voltage divider 10, and data about calibration factors and temperature correction factors. The sensed voltage of the conductor 20 is then transmitted by the SPCU 190 in a wireless manner via an antenna 210.

The voltage divider 10 and the SPCU 190 can be connected to electrical ground by a grounding tab 150.

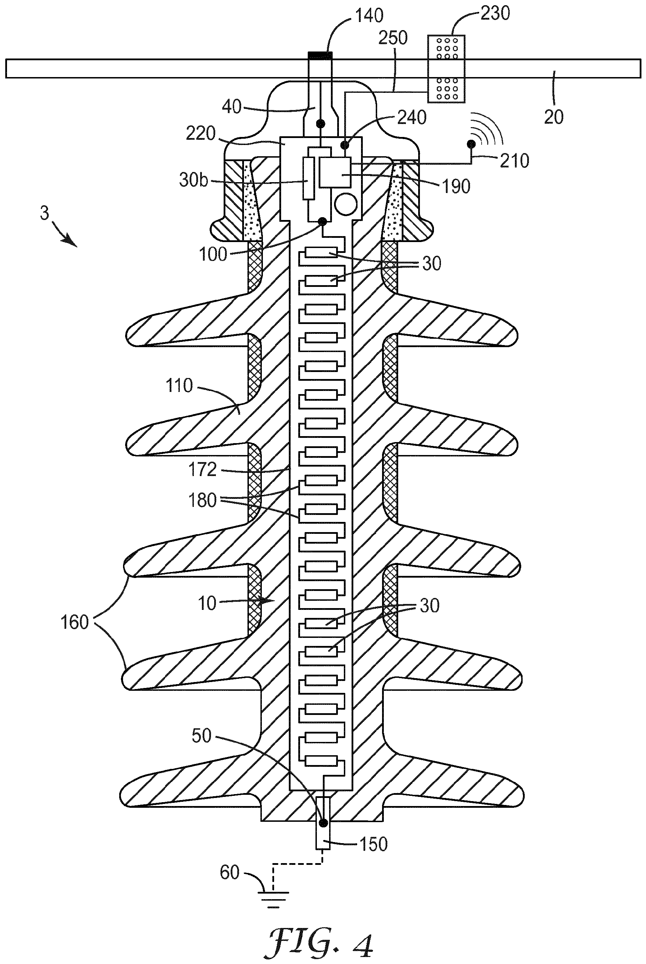

**Figure 4** is a partially sectional view of a further, third insulator 3 according to this disclosure, similar to the second insulator 2 of Figure 3. While the insulator body 110 is identical to the insulator body of the second insulator 2, the voltage sensor 10 is inverted, so that the sensing capacitor 30b and the signal processing and communication unit SPCU 190 are now located on the high-voltage end portion 220 of the PCB 172, close to the power line conductor 20. For this inverted design, the PCB 172 has essentially been turned by 180 degrees, so that also the harvesting voltage divider on the rear side of the PCB 172 is inverted. The inverted design allows for the same mechanism of voltage sensing by the plurality of discrete capacitors 30, 30b, connected in series between ground 60 and the power line conductor 20.

As a result, the SPCU 190 is not operated at a voltage at, or close to, electrical ground 60, but is operated at the elevated voltage of the power line conductor 20. The SPCU 190 is powered by a potential difference between the voltage of the overhead power line conductor 20 versus ground 60 and a voltage which is 5V lower than the voltage of the overhead power line conductor 20. With this inverted electrical design, additional sensors on the power line conductor 20 can be easily connected with the SPCU 190 without concerns about a large voltage difference between a sensor and the SPCU 190.

Figure 4 shows a current sensor 230 in the form of a Rogowski coil applied concentrically around the conductor 20. The current sensor 230 is electrically connected to the SPCU 190 via a sensor output signal wire 250 and sensor contact 240 on the PCB 172, so that the SPCU 190 can pick up and process the output signal of the current sensor 230, derive a value for the current flowing through the conductor 20 and transmit the current value, along with the voltage value derived from the signal voltage at the signal contact 100, in a wireless manner via antenna 210 to a grid management system.

The inverted design of the voltage sensor 10 facilitates connection of sensors on elevated voltage to the SPCU 190, because the SPCU 190 itself operates on a voltage close to the elevated voltage of the conductor 20. There is a reduced risk of an electrical discharge from the sensor 230 to the SPCU 190, and no massive insulation is required for cables connecting a sensor 230 with the SPCU 190.

Beyond the current sensor 230, or instead of it, other sensors for sensing other parameters can be attached to the power line conductor 20 and feed their signal via further dedicated signal contacts 240 into the SPCU 190 for processing and transmission of the sensed parameters to outside the insulator 3.

For example, a piezo vibration sensor can be mechanically attached to the power line conductor 20 to sense vibrations of the conductor 20. Due to the inverted design, an output signal wire 250 transporting the output signal of the vibration sensor can be connected with the SPCU 190 without requiring massive electrical insulation.

As another example, a temperature sensor can be mechanically attached to the power line conductor 20 to sense the temperature of the conductor 20, and its output signal can be transported by a output signal wire to the SPCU 190 for processing and wireless transmission to a grid management system.

## Claims

1. Insulator (1, 2, 3) for a medium-voltage or high-voltage overhead power line conductor (20) comprising
- an insulator body (110);
- a voltage contact (40) for electrically connecting the insulator to the power line conductor;
- a ground contact (50) for electrically connecting the insulator to ground (60); and
- a voltage sensor (10), embedded in the insulator body and comprising a first plurality of discrete impedance elements (30, 30a, 30b), electrically connected in series between the voltage contact and the ground contact such as to be operable as a first voltage divider (70) for dividing and sensing the voltage of the overhead power line conductor,
wherein the insulator further comprises a signal processing unit (190) for processing the sensed voltage of the overhead power line conductor (20) , wherein the signal processing unit is embedded, at least partially, in the insulator body (110),
**characterized in that** the signal processing unit (190) is powered by a potential difference between a first input voltage and a second input voltage, wherein the first input voltage is the voltage of the overhead power line conductor (20) versus ground (60), and the second input voltage differs from the first input voltage by 50 Volt or less or by 100 Volt or less.

2. Insulator (1, 2, 3) according to claim 1, further comprising a printed circuit board (170, 171, 172) having a first major surface and an opposed second major surface, wherein the first plurality of discrete impedance elements (30, 30a, 30b) is arranged on the first major surface.

3. Insulator according to any one of the preceding claims, wherein the insulator body (110) comprises porcelain, china, a ceramic material, glass and/or a polymeric material, such as an epoxy resin, natural rubber or ethylene propylene diene monomer rubber.

4. Insulator (1, 2, 3) according to any one of the preceding claims, further comprising a second plurality of discrete impedance elements, electrically connected in series between the voltage contact (40) and the ground contact (50) such as to be operable in a second voltage divider for harvesting electrical energy from the power line conductor (20).

5. Insulator (1, 2, 3) according to any one of the preceding claims, wherein the first plurality of discrete impedance elements (30, 30a, 30b) and/or the second plurality of discrete impedance elements is a plurality of discrete capacitors.

6. Insulator (1, 2, 3) according to any one of the preceding claims, wherein the first plurality of discrete impedance elements (30, 30a, 30b) and/or the second plurality of discrete impedance elements is a plurality of ten or more discrete impedance elements.

7. Insulator (1, 2, 3) according to any one of the preceding claims, having an elongated shape defining a first end portion and an opposed second end portion, wherein the voltage contact (40) is arranged at the first end portion and wherein the signal processing unit (190) is arranged at the first end portion.

8. Insulator (1, 2, 3) according to any one of the preceding claims, having an elongated shape defining a first end portion and an opposed second end portion, wherein the voltage contact (40) is arranged at the first end portion and wherein the signal processing unit (190) is arranged at the second end portion.

9. Insulator (3) according to any one of the preceding claims, further comprising a sensor contact (240) for electrically connecting a signal wire (250) of a further sensing unit (230) to the processing unit (190).

10. Insulator (3) according to claim 9, wherein the further sensing unit (230) comprises a current sensor (230), a temperature sensor, a pressure sensor, an acceleration sensor, a force sensor and/or a vibration sensor.

11. Insulator (2, 3) according to any one of the preceding claims, further comprising a wireless transmission device, operationally connected to the voltage sensor (10), for wirelessly transmitting a signal indicating the sensed voltage of the overhead power line conductor to an outside of the insulator.

12. Electrical power distribution network comprising an overhead power line comprising
a) a medium- or high-voltage overhead power line conductor (20), and
b) an insulator (1, 2, 3) according to any one of claims 1 to 11 supporting and insulating the overhead power line conductor.

## Patentansprüche

1. Isolator (1,2, 3) für einen Mittelspannungs- oder HochspannungsÜberlandleitungsleiter (20), aufweisend
- einen Isolatorkörper (110);
- einen Spannungskontakt (40) zum elektrischen Verbinden des Isolators mit dem Überlandleitungsleiter;
- einen Erdungskontakt (50) zum elektrischen Verbinden des Isolators mit Erde (60); und
- einen Spannungssensor (10), der in den Isolatorkörper eingebettet ist und aufweisend eine erste Mehrzahl von diskreten Impedanzelementen (30, 30a, 30b), die zwischen dem Spannungskontakt und dem Erdungskontakt elektrisch so in Reihe geschaltet sind, dass sie als ein erster Spannungsteiler (70) zum Teilen und Erfassen der Spannung des Überlandleitungsleiters betreibbar sind,
wobei der Isolator ferner eine Signalverarbeitungseinheit (190) zum Verarbeiten der erfassten Spannung des Überlandleitungsleiters (20) aufweist, wobei die Signalverarbeitungseinheit mindestens teilweise in den Isolatorkörper (110) eingebettet ist,
**dadurch gekennzeichnet, dass** die Signalverarbeitungseinheit (190) durch eine Potentialdifferenz zwischen einer ersten Eingangsspannung und einer zweiten Eingangsspannung gespeist wird, wobei die erste Eingangsspannung die Spannung des Überlandleitungsleiters (20) gegenüber Erde (60) ist und sich die zweite Eingangsspannung von der ersten Eingangsspannung um 50 Volt oder weniger oder um 100 Volt oder weniger unterscheidet.

2. Isolator (1, 2, 3) nach Anspruch 1, ferner aufweisend eine Leiterplatte (170, 171, 172) mit einer ersten Hauptoberfläche und einer gegenüberliegenden zweiten Hauptoberfläche, wobei die erste Mehrzahl von diskreten Impedanzelementen (30, 30a, 30b) auf der ersten Hauptoberfläche angeordnet ist.

3. Isolator nach einem der vorstehenden Ansprüche, wobei der Isolatorkörper (110) Porzellan, ein Keramikmaterial, Glas und/oder ein Polymermaterial, wie ein Epoxidharz, Naturkautschuk oder Ethylen-Propylen-Dien-Monomer-Kautschuk, aufweist.

4. Isolator (1, 2, 3) nach einem der vorstehenden Ansprüche, ferner aufweisend eine zweite Mehrzahl von diskreten Impedanzelementen, die zwischen dem Spannungskontakt (40) und dem Erdungskontakt (50) elektrisch so in Reihe geschaltet sind, dass sie in einem zweiten Spannungsteiler zum Gewinnen von elektrischer Energie von dem Stromleitungsleiter (20) betreibbar sind.

5. Isolator (1, 2, 3) nach einem der vorstehenden Ansprüche, wobei die erste Mehrzahl von diskreten Impedanzelementen (30, 30a, 30b) und/oder die zweite Mehrzahl von diskreten Impedanzelementen eine Mehrzahl von diskreten Kondensatoren ist.

6. Isolator (1, 2, 3) nach einem der vorstehenden Ansprüche, wobei die erste Mehrzahl von diskreten Impedanzelementen (30, 30a, 30b) und/oder die zweite Mehrzahl von diskreten Impedanzelementen eine Mehrzahl von zehn oder mehr diskreten Impedanzelementen ist.

7. Isolator (1, 2, 3) nach einem der vorstehenden Ansprüche, mit einer länglichen Form, die einen ersten Endabschnitt und einen gegenüberliegenden zweiten Endabschnitt definiert, wobei der Spannungskontakt (40) an dem ersten Endabschnitt angeordnet ist und wobei die Signalverarbeitungseinheit (190) an dem ersten Endabschnitt angeordnet ist.

8. Isolator (1, 2, 3) nach einem der vorstehenden Ansprüche, mit einer länglichen Form, die einen ersten Endabschnitt und einen gegenüberliegenden zweiten Endabschnitt definiert, wobei der Spannungskontakt (40) an dem ersten Endabschnitt angeordnet ist und wobei die Signalverarbeitungseinheit (190) an dem zweiten Endabschnitt angeordnet ist.

9. Isolator (3) nach einem der vorstehenden Ansprüche, ferner aufweisend einen Sensorkontakt (240) zum elektrischen Verbinden eines Signaldrahts (250) einer weiteren Erfassungseinheit (230) mit der Verarbeitungseinheit (190).

10. Isolator (3) nach Anspruch 9, wobei die weitere Erfassungseinheit (230) einen Stromsensor (230), einen Temperatursensor, einen Drucksensor, einen Beschleunigungssensor, einen Kraftsensor und/oder einen Schwingungssensor aufweist.

11. Isolator (2, 3) nach einem der vorstehenden Ansprüche, ferner aufweisend eine Drahtlosübertragungsvorrichtung, die mit dem Spannungssensor (10) zum drahtlosen Übertragen eines Signals, das die erfasste Spannung des Überlandleitungsleiters angibt, an eine Außenseite des Isolators, betreibbar verbunden ist.

12. Elektrisches Stromverteilungsnetz, aufweisend eine Überlandleitung, aufweisend
a) einen Mittel- oder Hochspannungsüberlandleitungsleiter (20), und
b) einen Isolator (1, 2, 3) nach einem der Ansprüche 1 bis 11, der den Überlandleitungsleiter trägt und isoliert.

## Revendications

1. Isolateur (1,2, 3) pour un conducteur de ligne de puissance aérienne moyenne tension ou haute tension (20) comprenant
- un corps d'isolateur (110) ;
- un contact de tension (40) pour connecter électriquement l'isolateur au conducteur de ligne de puissance ;
- un contact de terre (50) pour connecter électriquement l'isolateur à la terre (60) ; et
- un capteur de tension (10), intégré dans le corps d'isolateur et comprenant une première pluralité d'éléments d'impédance distincts (30, 30a, 30b), électriquement connectés en série entre le contact de tension et le contact de terre de façon à être fonctionnels en tant que premier diviseur de tension (70) pour diviser et capter la tension du conducteur de ligne de puissance aérienne,
dans lequel l'isolateur comprend en outre une unité de traitement de signal (190) pour traiter la tension captée du conducteur de ligne de puissance aérienne (20), dans lequel l'unité de traitement de signal est intégrée, au moins partiellement, dans le corps d'isolateur (110),
**caractérisé en ce que** l'unité de traitement de signal (190) est alimentée en puissance par une différence de potentiel entre une première tension d'entrée et une deuxième tension d'entrée, dans lequel la première tension d'entrée est la tension du conducteur de ligne de puissance aérienne (20) par rapport à la terre (60), et la deuxième tension d'entrée diffère de la première tension d'entrée de 50 volts ou moins ou de 100 volts ou moins.

2. Isolateur (1, 2, 3) selon la revendication 1, comprenant en outre une carte à circuit imprimé (170, 171, 172) ayant une première surface principale et une deuxième surface principale opposée, dans lequel la première pluralité d'éléments d'impédance distincts (30, 30a, 30b) est agencée sur la première surface principale.

3. Isolateur selon l'une quelconque des revendications précédentes, dans lequel le corps d'isolateur (110) comprend de la porcelaine, de la faïence, un matériau céramique, du verre et/ou un matériau polymère, tel qu'une résine époxy, du caoutchouc naturel ou du caoutchouc monomère d'éthylène-propylène-diène.

4. Isolateur (1, 2, 3) selon l'une quelconque des revendications précédentes, comprenant en outre une deuxième pluralité d'éléments d'impédance distincts, électriquement connectés en série entre le contact de tension (40) et le contact de terre (50) de façon à être fonctionnels dans un deuxième diviseur de tension pour récolter de l'énergie électrique provenant du conducteur de ligne de puissance (20).

5. Isolateur (1, 2, 3) selon l'une quelconque des revendications précédentes, dans lequel la première pluralité d'éléments d'impédance distincts (30, 30a, 30b) et/ou la deuxième pluralité d'éléments d'impédance distincts sont une pluralité de condensateurs distincts.

6. Isolateur (1, 2, 3) selon l'une quelconque des revendications précédentes, dans lequel la première pluralité d'éléments d'impédance distincts (30, 30a, 30b) et/ou la deuxième pluralité d'éléments d'impédance distincts sont une pluralité de dix éléments d'impédance distincts ou plus.

7. Isolateur (1, 2, 3) selon l'une quelconque des revendications précédentes, ayant une forme allongée définissant une première partie d'extrémité et une deuxième partie d'extrémité opposée, dans lequel le contact de tension (40) est agencé au niveau de la première partie d'extrémité et dans lequel l'unité de traitement de signal (190) est agencée au niveau de la première partie d'extrémité.

8. Isolateur (1, 2, 3) selon l'une quelconque des revendications précédentes, ayant une forme allongée définissant une première partie d'extrémité et une deuxième partie d'extrémité opposée, dans lequel le contact de tension (40) est agencé au niveau de la première partie d'extrémité et dans lequel l'unité de traitement de signal (190) est agencée au niveau de la deuxième partie d'extrémité.

9. Isolateur (3) selon l'une quelconque des revendications précédentes, comprenant en outre un contact de capteur (240) pour connecter électriquement un fil de signal (250) d'une unité de captage supplémentaire (230) à l'unité de traitement (190).

10. Isolateur (3) selon la revendication 9, dans lequel l'unité de captage supplémentaire (230) comprend un capteur de courant (230), un capteur de température, un capteur de pression, un capteur d'accélération, un capteur de force et/ou un capteur de vibration.

11. Isolateur (2, 3) selon l'une quelconque des revendications précédentes, comprenant en outre un dispositif de transmission sans fil, fonctionnellement connecté au capteur de tension (10), pour transmettre sans fil un signal indiquant la tension captée du conducteur de ligne de puissance aérienne à l'extérieur de l'isolateur.

12. Réseau de distribution de puissance électrique comprenant une ligne de puissance aérienne comprenant
a) un conducteur de ligne de puissance aérienne moyenne ou haute tension (20), et
b) un isolateur (1, 2, 3) selon l'une quelconque des revendications 1 à 11 soutenant et isolant le conducteur de ligne de puissance aérienne.
